# EUROPEAN PATENT APPLICATION

(11) **EP 3 139 704 A1**
(43) Date of publication of application: **08.03.2017**
(21) Application number: 15785709.5
(22) Date of filing: 06.03.2015
(51) Int. Cl.: H05B 33/02, C03C 3/078, C03C 3/085, C03C 3/095, C03C 3/097, H01L 51/50

(54) **GLASS SUBSTRATE, ORGANIC EL ILLUMINATOR, AND PROCESS FOR PRODUCING GLASS SUBSTRATE**

(30) Priority: 01.05.2014 JP 2014094895; 07.10.2014 JP 2014206783
(71) Applicant: Toyo Seikan Group Holdings, Ltd., Tokyo 141-8640 (JP)
(72) Inventor: ISHIDA Tomoyuki, Kashiwa-shi Chiba 277-0804 (JP); IWATA Sohtaro, Kashiwa-shi Chiba 277-0804 (JP); NAKATO Hideo, Tokyo 102-8447 (JP)
(74) Representative: Hammond, David Matthew
(86) International application number: PCT/JP2015/056593
(87) International publication number: WO 2015/166708

(57) **Abstract**

A glass substrate for an organic EL element, which can improve the light-extraction efficiency of the organic EL element, can be produced with a high productivity. The glass substrate serves as a light-extraction side transparent substrate of an organic EL element. The refractive index λd of the glass substrate is 1.60 or more, and Na₂O + K₂O are contained at 10 mol% to 20 mol% as glass components. Alight-extraction side surface has a relief structure obtained by die molding.

## Description

### [Technical Field]

The present invention relates to a glass substrate, an organic EL illuminator using the same, and a method for producing a glass substrate.

### [Background Art]

Organic EL (Electroluminescence) elements are spontaneous light-emitting elements capable of surface emission, and they have attracted attention as components of organic EL devices such as thin illuminating light sources and flat panel displays. An organic EL element is provided with a stacked film structure in which a transparent conductive layer, an organic layer, a metal conductive layer and the like are formed on a transparent substrate such as a glass substrate, and light emitted in the organic layer as a result of voltage application between a pair of electrode layers configured of the transparent conductive layer and metal conductive layer is transmitted through the transparent conductive layer and transparent substrate and extracted to the outside.

In such an organic EL element, since the refractive index of the organic layer or transparent conductive layer is significantly higher than the refractive index of the transparent substrate, a phenomenon occurs such that some of the light emitted in the organic layer undergoes total reflection at the interface of the transparent conductive layer and the transparent substrate or at the interface of the transparent substrate and an air layer and is confined inside the element, thereby making it impossible to extract the entire emitted light to the outside. The ratio of the light that can be extracted to the outside to the emitted light is called a light-extraction efficiency, and increasing the light-extraction efficiency is an important issue for organic EL devices, in particular illuminators in which a high brightness is wished to be obtained at a minimum power consumption.

In the related art, a resin film having a relief surface shape has been attached to the outer surface of the transparent substrate to improve the light-extraction efficiency (see Patent Literature 1 below). It has also been suggested to increase the refractive index of the glass substrate serving as the transparent substrate and roughen the surface thereof by processing such as alumina polishing and sandblasting (see Patent Literature 2 below) or form a relief structure on a glass surface by performing etching or processing with a dicing saw (see Patent Literature 3 below).

### [Citation List]

### [Patent Literature]

[Patent Literature 1] Japanese Patent Application Publication No. 2011-29163
[Patent Literature 2] Japanese Patent Application Publication No. 2013-149406
[Patent Literature 3] Japanese Patent Application Publication No. 2008-10245

### [Summary of Invention]

### [Technical Problem]

In the related art in which the aforementioned resin film is attached to the transparent substrate, the resin film incurs significant expense and a complex step of bonding the resin film uniformly to the surface of the transparent substrate is added. The resulting problem is that the production cost of an organic EL device increases and a high productivity cannot be attained.

Further, when a glass substrate with a high refractive index is formed and the surface thereof is then processed, where roughening is performed by alumina polishing or sandblasting, the resulting problem is that microcracks tend to be induced by such roughening in the glass substrate with a high refractive index and the physical strength of the glass substrate is decreased. To resolve this problem, in the related art disclosed in the aforementioned Patent Literature 2, the microcracks are removed by chemical treatment of the glass substrate after the roughening. However, even in such an example, not only the step of roughening is added, but also the step of chemical treatment is added. Furthermore, a certain time is spent on drying and removing the chemical reagent after the treatment. The resulting problem is that a high productivity cannot be attained when a transparent substrate for an organic EL element is produced.

In the related art in which a relief structure is formed on the surface of a glass substrate by performing etching or processing with a dicing saw, a certain time is also needed because of the addition of the processing step and also for drying the etching solution after the processing, etc. The resulting problem is that, same as in the case of the aforementioned related art, a high productivity cannot be attained when the transparent substrate for an organic EL element is produced.

The present invention aims at, among others, solving the aforementioned problems. Thus, it is an objective of the present invention to provide a glass substrate for an organic EL element that, without using a resin film, can improve the light-extraction efficiency of the organic EL element, and also to enable high-productivity production of a glass substrate for an organic EL element that can improve the light-extraction efficiency of the organic EL element.

### [Solution to Problem]

In order to attain the abovementioned objective, the present invention adopts the following features related of some of aspects of the invention disclosed in the specification.

A glass substrate serving as a light-extraction side transparent substrate of an organic EL element, wherein a refractive index λd is 1.60 or more, Na₂O + K₂O are contained at 10 mol% to 20 mol% as glass components, and a light-extraction side surface has a relief structure obtained by die molding.

A method for producing a glass substrate serving as a light-extraction side transparent substrate of an organic EL element, the method comprising a step of molding melting glass containing TiO₂ at 12 mol% to 24 mol%, BaO at 5 mol% to 15 mol%, and Na₂O + K₂O at 10 mol% to 20 mol% as glass components into a thin-plate shape by rolling or extending, and a step of performing die pressing for forming a relief structure on a surface simultaneously with said molding step or thereafter.

### [Advantageous Effects of Invention]

With the invention having such features, since the refractive index λd of the glass substrate is 1.60 or more and a relief structure is provided on the light-extraction side surface of the glass substrate, it is possible to improve the light-extraction efficiency of the organic EL element using the glass substrate as a light-extraction side transparent substrate. Since the relief structure on the light-extraction side surface of the glass substrate is formed by die molding, the molding can be rapidly performed simultaneously with the rolling or extending step of forming the glass substrate from melting glass or thereafter, and a glass substrate that can improve the light-extraction efficiency of the organic EL element can be produced with a high productivity.

### [Brief Description of Drawings]

Fig. 1 is an explanatory drawing illustrating a method for producing a glass substrate according to an embodiment of the present invention. Fig. 1(a) illustrates a method for molding a glass substrate by roll-out molding, and Fig. 1(b) illustrates a method for molding a glass substrate by slit-down molding.
Fig. 2 is an explanatory drawing illustrating an exemplary embodiment of a die provided to a second molding roller 3 depicted in Fig. 1(a) and a molding roller 11 depicted in Fig. 1(b).
Fig. 3 is an explanatory drawing (cross-sectional view) illustrating a configuration example of a glass substrate according to an embodiment of the present invention.
Fig. 4 is an explanatory drawing (plan view) illustrating a configuration example of a glass substrate according to an embodiment of the present invention.
Fig. 5 is an explanatory drawing illustrating another example of the method for producing a glass substrate according to an embodiment of the present invention.
Fig. 6 is an explanatory drawing illustrating a model configuration for simulation calculations of the "light-extraction efficiency" of a glass substrate according to an embodiment of the present invention. Fig. 6(a) shows schematically the configuration conditions of a light-emitting element, and Fig. 6(b) is a cross-sectional view of a convex lens array formed on the surface of the glass substrate.
Fig. 7 is a graph illustrating calculation results obtained when the relief structure is taken as part of a spherical lens in the simulation of the "light-extraction efficiency" (Fig. 7(a) is the relationship between the light-extraction efficiency and the ratio of lens surface, Fig. 7(b) is the relationship between the light-extraction efficiency and the lens diameter, and Fig. 7(c) is the relationship between the light-extraction efficiency and the lens height.
Fig. 8 is an explanatory drawing illustrating an organic EL element provided with the glass substrate according to an embodiment of the present invention.

### [Description of Embodiments]

In the glass substrate according to an embodiment of the present invention, the refractive index λd is 1.60 or more. As a result of the refractive index λd of the glass substrate being 1.60 or more, the difference in refractive index between the glass substrate and a transparent conductive layer (ITO or the like) or an organic layer can be reduced, and the ratio of light confined in the organic EL element due to total reflection occurring on the interface of the glass substrate and the transparent conductive layer, or the like, in the light emitted in the organic layer can be reduced. It is preferred that the refractive index λd of the glass substrate is 1.70 or less. As a result, the difference in refractive index between the glass substrate and the air layer outside thereof can be made comparatively small, and the ratio of light confined in the organic EL element due to total reflection occurring on the interface of the glass substrate and the air layer in the light emitted in the organic layer can be reduced.

The refractive index herein is a refractive index of a d-ray (588 nm) measured with a commercial refractive index meter. It is measured, for example, by using a precision refractive index meter (KPR-30V) manufactured by Kalnew Optical Industrial Co., Ltd.

The refractive index λd in a glass substrate can be adjusted, as appropriate, by a glass composition. Glass components for increasing the refractive index λd include refractive index adjusting components such as TiO₂ BaO, and ZnO which are contained in appropriate amounts with respect to SiO₂ which is the principal component. In order to obtain the refractive index λd of the glass substrate which is 1.60 or more, TiO₂ is contained at 12 mol% to 24 mol%, preferably 12 mol% to 20 mol%, and BaO is contained at 5 mol% to 15 mol%, preferably 10 mol% to 15 mol%. Further, ZnO can be contained, as necessary, at 0 mol% to 14 mol%. By increasing the content rate of TiO₂, BaO, and ZnO, it is possible to increase the refractive index λd, but where the content rate of TiO₂ is too high, coloration or crystallization of the glass substrate tends to occur. Where the content rate of BaO is too high, the glass substrate is difficult to mold into a plate, and where the content rate of ZnO is too high, crystallization tends to occur.

In addition to TiO₂ BaO, and ZnO, such components as Al₂O₃, Bi₂O₃, La₂O₃, Nb₂O₅, and Y₂O₃ can be selectively contained as the refractive index adjusting components among the glass components. It is preferred that one or a plurality of components selected from among these components be contained at 5 mol% or less.

The glass substrate according to the embodiment of the present invention has a relief structure formed by die molding on the light-extraction side surface of an organic EL element. The feature of providing a relief structure on the light-extraction side surface of a glass substrate is well known, as disclosed in the abovementioned related art, and it is also well known that such a relief structure can suppress the phenomenon of the light emitted from the organic layer being confined inside the organic EL element due to total reflection at the interface of the glass substrate and the air layer. However, where the relief structure is to be formed by processing such as roughening or etching of the glass substrate surface, as in the related art, complex processing steps are added and a step of subsequent chemical treatment and removal of the chemical reagent by drying after the chemical treatment is also added, the time required for the entire process of producing the glass substrate is increased and a high productivity cannot be obtained.

By contrast, in the glass substrate of the embodiment of the present invention, a relief structure is formed on the light-extraction side surface of the glass substrate by die molding. As a result, a step of die molding can be simply implemented with respect to the melting glass heated in the step of rolling or extending the melting glass which has been performed in the usual production of glass substrates, and it is not necessary to provide a step of chemical treatment and drying and removal of the chemical reagent. Therefore, a relief structure can be formed on the light-extraction side surface of a glass substrate, without extending significantly the time required for the entire process of producing the glass substrate. A glass substrate that can improve the light-extraction efficiency of the organic EL element can thus be obtained with a high productivity.

A moldability improving component is contained in an appropriate amount, in addition to the above-described refractive index adjusting component(s), as a glass component of the glass substrate according to the embodiment of the present invention. The moldability improving component is necessary for obtaining a viscosity suitable for molding the melting glass heated to 1000°C or less. Problems associated with the glass containing no such component are that heating at a temperature significantly higher than 1000°C is needed in order to obtain the viscosity necessary for molding, excessive heat resistance is required for a die (metal die) necessary for performing the die molding, and limitations are placed on the dimensions and shape of the relief structure which is to be molded. In the glass substrate according to the embodiment of the present invention, since the moldability improving component is contained at the appropriate amount, it is possible to obtain a suitable viscosity needed for die molding at a comparatively low temperature of, for example, 600°C to 1000°C.

The glass substrate according to the embodiment of the present invention contains the appropriate amount of an alkali component as the moldability improving component. Na₂O and K₂O are contained in appropriate amounts as the alkali components. In order to obtain the satisfactory die moldability, it is preferred that Na₂O + K₂O be contained at 10 mol% to 20 mol% as the glass components. Since Na₂O is a component that can increase the refractive index of the glass substrate by replacing SiO₂ which is the main component of the glass substrate, in order to increase the refractive index, it is preferred that the component content rate of Na₂O in Na₂O + K₂O be greater than the component content rate of K₂O. Further, since K₂O acts to suppress the crystallization of TiO₂ it is preferred that K₂O be contained at 1 mol% to 10 mol% in Na₂O + K₂O.

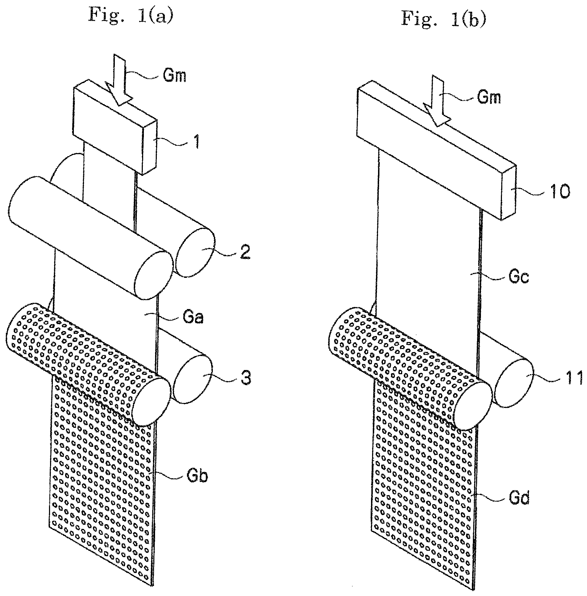

Fig. 1 illustrates a method for producing a glass substrate according to an embodiment of the present invention. Fig. 1(a) illustrates a method for molding a glass substrate by roll-out molding, and Fig. 1(b) illustrates a method for molding a glass substrate by slit-down molding. With the roll-out molding depicted in Fig. 1(a), melting glass Gm supplied from a melting equipment (not depicted in the figure) is supplied to first molding rollers 2 through an orifice 1. The melting glass of a predetermined thickness which has passed through the orifice 1 is rolled or extended by the first molding rollers 2 to form a thin-plate shape glass Ga. After passing between the first molding rollers 2, the thin-plate shape glass Ga is molded with second molding rollers 3 to form a glass substrate Gb of a set thickness. In this case, a die for forming a relief structure is formed on one surface of the pair of second molding rollers 3, and a relief structure is formed on one surface of the glass substrate Gb by pressing the die and molding.

With the slit-down molding depicted in Fig. 1(b), the melting glass Gm is supplied from the melting equipment (not depicted in the figure) in the same manner as in the roll-out molding, and curtain-like glass Gc is formed by allowing the supplied melting glass Gm to pass through a slit orifice 10. A glass substrate Gd of a set thickness is formed by extending the curtain-like glass Gc with the molding rollers 11. In this case, a die for forming a relief structure is formed on one of the pair of molding rollers 11, and the relief structure is formed on one surface of the glass substrate Gd by pressing the die and molding.

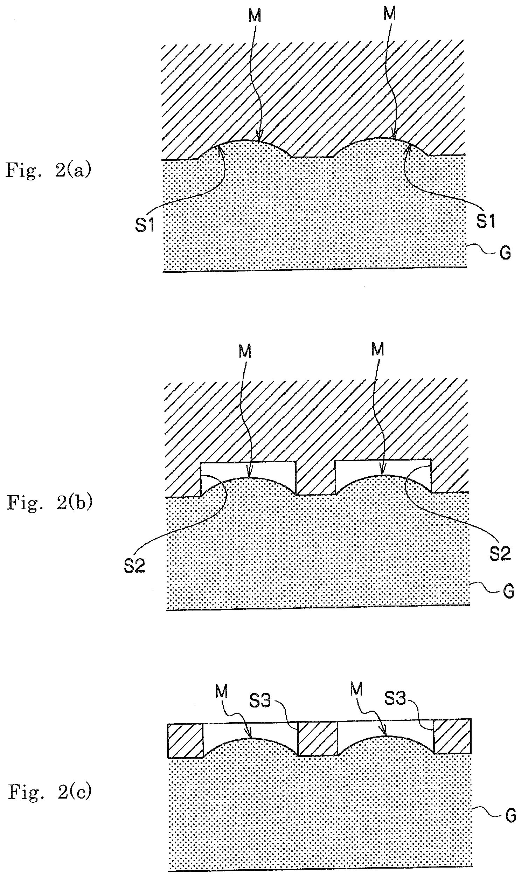

Fig. 2 illustrates an exemplary embodiment of a die provided to a second molding roller 3 depicted in Fig. 1(a) and a molding roller 11 depicted in Fig. 1(b). In the die of the example depicted in Fig. 2(a), curved concave parts S1 are arranged parallel to each other. As a result of pressing such a die against the surface of the glass substrate with a temperature adjusted to 600°C to 1000°C by cooling or heating, a relief structure in which curved convex parts M are arranged parallel to each other is formed on the surface of the glass substrate G having a predetermined viscosity. In the die of the example depicted in Fig. 2(b), recessed parts S2 with a rectangular cross section are formed parallel to each other. In the die of the example depicted in Fig. 2(c), punching parts S3 are arranged parallel to each other. As a result of pressing such dies against the surface of the glass substrate with a temperature adjusted to 600°C to 1000°C by cooling or heating, a relief structure in which curved convex parts M are arranged parallel to each other is formed by the surface tension on the surface of the glass substrate G having a predetermined viscosity.

The dies depicted in Figs. 2(b) and 2(c) have inner die surfaces which do not come into contact with the surface of the curved convex parts M formed in the glass substrate G. When such dies are used, since the inner surfaces of the die do not come into contact with the surface of the curved convex parts M formed on the surface of the glass substrate G, the generation of bubbles at the surface of the glass substrate G can be suppressed. As a result, a defect ratio in formation of the relief structure at the glass substrate G can be suppressed, the yield can be increased, and the production efficiency can be increased.

Although the die is formed on the surface of the molding roller in the examples depicted in the figures, a similar relief structure can be also formed on the surface of the glass substrate G by pressing a press plate, rather than the roller, on which a die of the above-described shape was formed.

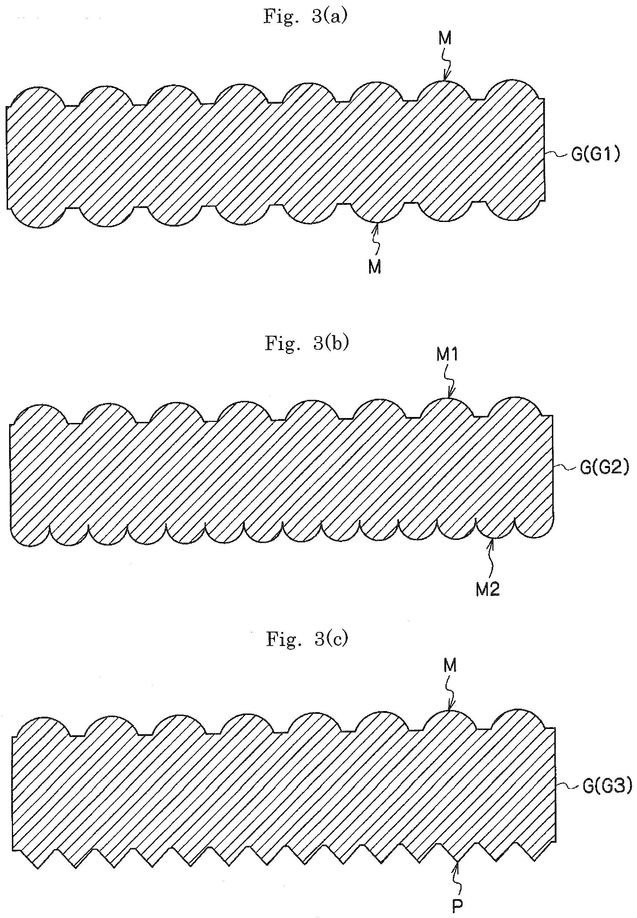

In a glass substrate according to another embodiment of the present invention, not only the light-extraction side surface has the relief structure molded by the die, as described hereinabove, but also a rear face of the light-extraction side surface in the glass substrate has a relief structure molded by a die. Fig. 3 depicts an example in which a relief structure is provided on both the front face and the rear face of the glass substrate G. The relief structure formed on both the front face and the rear face of the glass substrate G can be formed reversely symmetrical, as depicted in Fig. 3(a), or reversely asymmetrical, as depicted in Figs. 3(b) and 3(c). In the example, depicted in Fig. 3(a), the relief structure is formed on both the front face and the rear face by forming a plurality of curved convex parts M of the same pattern on the front face and the rear face of the glass substrate G (G1), and a lens array is formed by the plurality of curved convex parts M. In the example, depicted in Fig. 3(b), lens arrays are formed on the front face and the rear face in the glass substrate G (G2) by making the diameter of curved convex parts M1 formed on one of the front face and the rear face larger than the diameter of curved convex parts M2 formed on the other of the front face and the rear face. In the example, depicted in Fig. 3(c), a plurality of curved convex parts M is formed on one of the front face and the rear face of the glass substrate G (G3), and a plurality of conical or pyramidal convex parts P are formed on the other face. As a result, a lens array is formed on one side where the curved convex parts M have been formed, and a prism array is formed on the other side where the conical or pyramidal convex parts P have been formed.

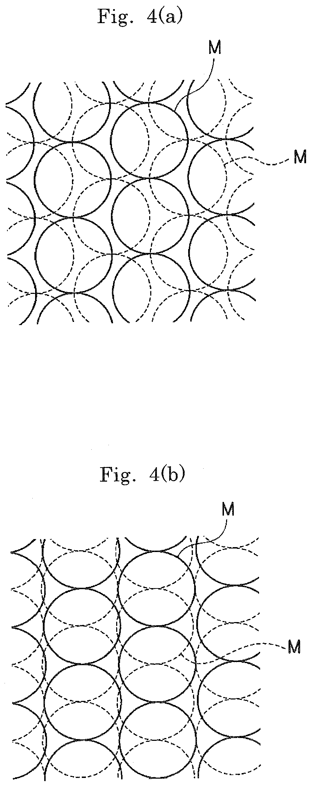

Fig. 4 shows a planar arrangement pattern of a relief structure formed on the front face and the rear face of a glass substrate. Solid lines in the figure depict a relief structure pattern on one of the front face and the rear face, and broken lines in the figure depict a relief structure pattern on the other of the front face and the rear face. The patterns of relief structures formed on the front face and the rear face of the glass substrate can be formed to match in a planar view. Further, the arrangement patterns of the curved convex parts M on the front face and the rear face can be shifted with respect to each other in the direction perpendicular to the row direction of the curved convex parts M, which are disposed linearly, by 1/2 of the diameter of the curved convex part M, as depicted in Fig. 4(a), or the arrangement patterns of the curved convex parts M on the front face and the rear face can be shifted with respect to each other in the direction perpendicular to the row direction of the curved convex parts M, which are disposed linearly, by the diameter of the curved convex part M, as depicted in Fig. 4(b).

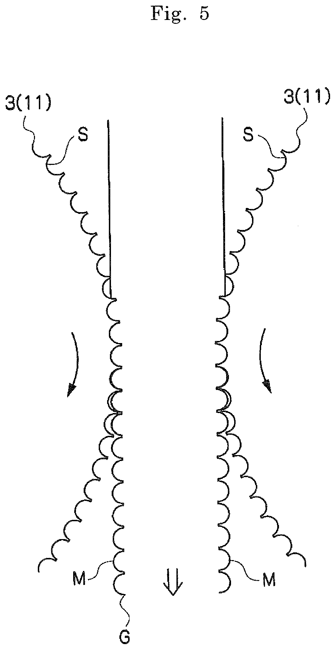

Even when the relief structure is formed on both the front face and the rear face of the glass substrate G, as depicted in Figs. 3 and 4, both of the relief structures are formed in a step of die pressing shown in Figs. 1 and 2. Further, by providing a die S on each of a pair of rollers in the first molding rollers 2 or the second molding rollers 3, as depicted in Fig. 5, it is possible to form the relief structure composed of curved convex parts M, or the like at the same time on the front face and the rear face of the glass substrate G. In this way, the arrangement relationship of the relief structures formed on both the front face and the rear face of the glass substrate G can be set with good accuracy.

Examples of glass components of the glass substrate according to the embodiment of the present invention are described hereinbelow. Tables 1, 2, and 3 represent examples of the present invention and comparative examples. Samples No. 1 to No. 9 in Tables 1 and 2 represent examples of the present invention, and samples No. 10 to No. 12 in Table 3 represent comparative examples. Units of the numerical values of the compounding ratios of glass components in Tables 1 to 3 are mol%.

**[Table 1]**

| Component \ Sample | No. 1 | No. 2 | No. 3 | No. 4 |
|---|---|---|---|---|
| SiO₂ | 63.49 | 60.0 | 60.0 | 65.0 |
| Na₂O | 8.39 | 10.0 | 5.0 | 5.0 |
| K₂O | 5.52 | 5.0 | 10.0 | 5.0 |
| TiO₂ | 12.16 | 15.0 | 15.0 | 15.0 |
| BaO | 3.62 | 5.0 | 5.0 | 5.0 |
| ZnO | 6.82 | 5.0 | 5.0 | 5.0 |
| Refractive index | 1.606 | 1.633 | 1.622 | 1.624 |
| Die moldability | Good | Good | Good | Good |
| Note | | | | |

**[Table 2]**

| Component \ Sample | No. 5 | No. 6 | No. 7 | No. 8 | No. 9 |
|---|---|---|---|---|---|
| SiO₂ | 65.0 | 55.0 | 60.0 | 60.0 | 50.0 |
| Na₂O | 5.0 | 5.0 | 5.0 | 5.0 | 5.0 |
| K₂O | 10.0 | 10.0 | 15.0 | 10.0 | 10.0 |
| TiO₂ | 15.0 | 15.0 | 15.0 | 20.0 | 15.0 |
| BaO | 5.0 | 5.0 | 10.0 | 5.0 | 15.0 |
| ZnO | 0.0 | 10.0 | 0.0 | 0.0 | 5.0 |
| Refractive index | 1.606 | 1.638 | 1.627 | 1.644 | 1.659 |
| Die moldability | Good | Good | Good | Good | Good |
| Note | | | | | |

**[Table 3]**

| Component \ Sample | No. 10 | No. 11 | No. 12 |
|---|---|---|---|
| SiO₂ | 65.0 | 65.0 | 50.0 |
| Na₂O | 5.0 | 5.0 | 5.0 |
| K₂O | 10.0 | 0.0 | 10.0 |
| TiO₂ | 10.0 | 20.0 | 25.0 |
| BaO | 5.0 | 5.0 | 5.0 |
| ZnO | 5.0 | 5.0 | 5.0 |
| Refractive index | 1.585 | | |
| Die moldability | Good | Poor | |
| Note | | | Large coloration |

Blocks of samples for measuring the refractive index in Tables 1 to 3 were produced by placing 250 g of glass raw materials compounded such as to obtain the glass compositions described in the tables in a glass melting furnace (platinum crucible) and melting at 1400°C to 1500°C. The temperature was then lowered, the components were stirred for 15 min with a platinum stirrer, and the melt was cast into an iron die (70 x 70 x 20 mm). Each block was placed into an electric furnace and gradually cooled by lowering the temperature to obtain glass. A sample was obtained by cutting out a small piece (about 10 x 10 x 5 mm) from the glass. A refractive index of a d-ray (588 nm) was measured using a precision refractive index meter (KPR-30V) manufactured by Kalnew Optical Industrial Co., Ltd.

In the evaluation of die moldability in Tables 1 to 3, glass raw materials compounded such as to obtain the glass compositions described in the tables were melted at 1400°C to 1500°C and then molded into a thin-plate shape. The temperature was then lowered to 600°C to 1000°C, and in this state, a circular flat die with a diameter of 100 µm to 800 µm was pressed against the plate and separated therefrom. The plate was then gradually cooled, and it was evaluated whether or not the molding was performed with a relief difference of 10 µm to 20 µm or more. Where the relief difference of 10 µm to 20 µm or more was formed, the evaluation was "Good", and where such relief difference was not formed, the evaluation was "Poor".

As shown by the samples in Tables 1 and 2, for samples No. 1 to No. 9 which contained 10 mol% to 20 mol% of Na₂O + K₂O, which are alkali components, in the glass compositions with a refractive index λd of 1.60 or more, the die moldability was "Good" and a relief structure effective for improving the light-extraction efficiency could be formed by die pressing in a state in which the temperature was adjusted to a range of 600°C to 1000°C. By contrast, as shown by sample No. 11 in Table 3, when the alkali components were contained at less than 10 mol% (only Na₂O was at 5 mol%), a predetermined relief difference could not be obtained after lowering the temperature to 600°C to 1000°C.

When the content rate of BaO, which is a glass component for increasing the refractive index, is made about 5 mol% to 15 mol% in the glass composition containing 10 mol% to 20 mol% of Na₂O + K₂O, which are alkali components, a content of TiO₂ of 12 mol% to 24 mol% is effective for increasing the refractive index λd of the glass substrate to 1.60 or more. Where a large amount of BaO is compounded, a plate is difficult to mold. Therefore, it is preferred that the content rate thereof be suppressed to a predetermined range. Further, where the content rate of TiO₂ is 25 mol% or more, as in sample No. 12, in such glass composition, coloration of the glass substrate increases and good transparency cannot be ensured.

Discussed hereinbelow is a light-extraction efficiency improvement effect obtained when a relief structure is formed by die molding on a glass substrate. Here, a convex lens array shape was considered as an example of the relief structure that can be formed by die molding, and the light-extraction efficiency under predetermined conditions were simulation calculated by a light ray tracing method. In the light ray tracing method, a total of 20,000 light rays which were randomly emitted from the light-emitting face of a complete diffusion surface were traced and emitted to the outside from the glass substrate having a convex lens array on the surface, and the ratio of light rays that reached the sensor surface was taken as the "light-extraction efficiency".

The calculation conditions are described below. Light-emitting surface area: 10 mm x 10 mm. Two-layer structure with a thickness of light-emitting portion d1 = 0.2 + 0.2 mm, where the light-emitting surface is the uppermost surface. The refractive index of the light-emitting portion: 1.591. The thickness of the transparent conductive layer (ITO) d2 = 0.0001 mm. The refractive index of the transparent conductive layer: 2.095. The thickness of the glass substrate d3 = 0.3 mm. The sensor surface is assumed to detect light rays in a virtual sensor disposed above the glass substrate at a distance of 0.05 mm (d4) therefrom.

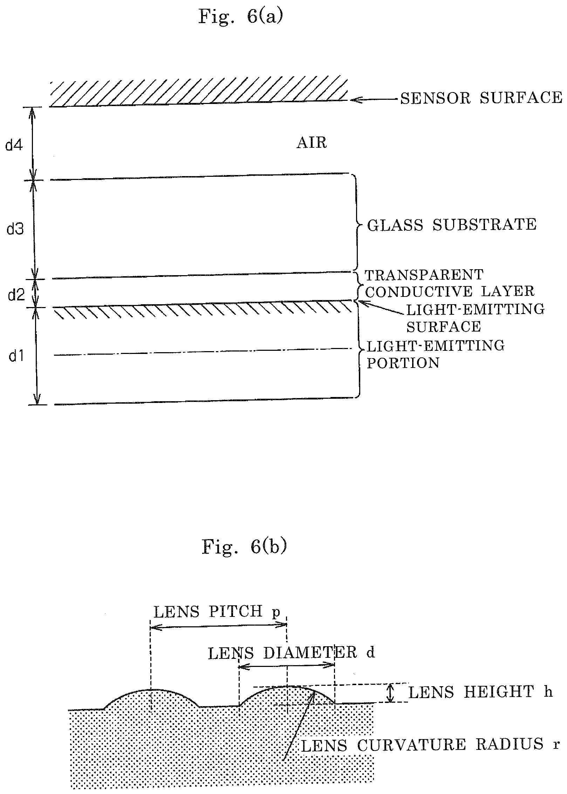

Fig. 6 shows a model configuration for simulation calculations of the "light-extraction efficiency" of the glass substrate. Fig. 6(a) illustrates schematically the configuration conditions of the abovementioned light-emitting element, and Fig. 6(b) is a cross-sectional view of the convex lens array formed on the surface of the glass substrate.

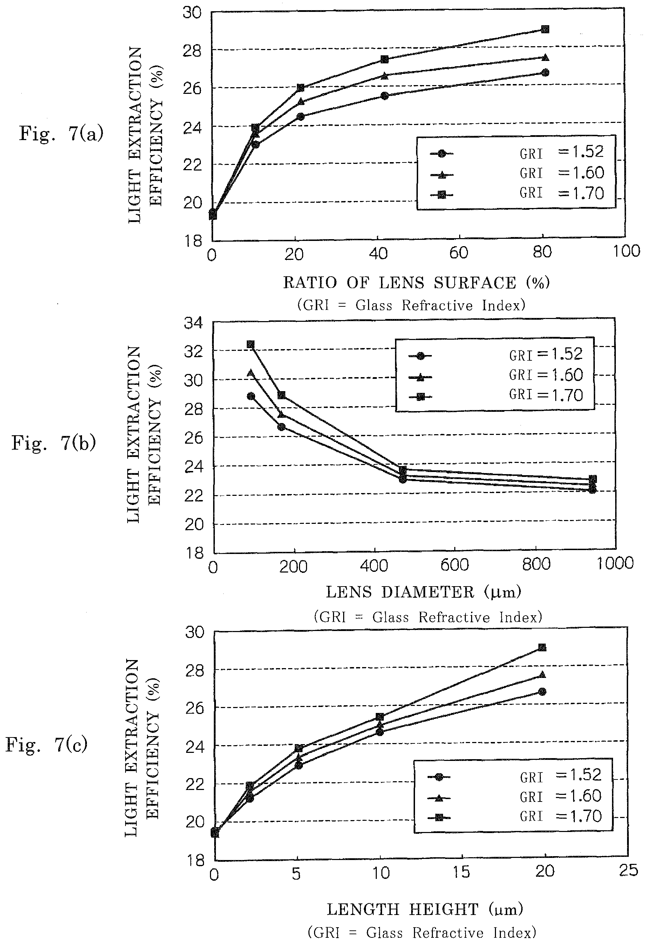

In Figs. 7(a), 7(b), and 7(c), the calculation results are shown in a graphical form. Fig. 7(a) illustrates the relationship between the light-extraction efficiency (%) and the ratio of the lens surface (%: ratio of surface area occupied by lenses) in the case where each lens has constant curvature radius r = 190 µm and lens height h = 20 µm. The figure clearly shows that the light-extraction efficiency can be increased by increasing the ratio of the lens surface and the refractive index of the glass substrate. In particular, the light-extraction efficiency can be effectively increased by setting the refractive index of the glass substrate to 1.60 or more with the ratio of lens surface being within a range of 10% to 80%.

Fig. 7(b) illustrates the relationship between the light-extraction efficiency (%) and the lens diameter d (µm) in the case with constant lens height h = 20 µm and lens surface ratio = 80.6%. The figure clearly shows that the light-extraction efficiency can be increased by decreasing the lens diameter and increasing the refractive index of the glass substrate. In particular, the light-extraction efficiency can be effectively increased by setting the refractive index of the glass substrate to 1.60 or more with the lens diameter being within a range of 100 µm to 430 µm.

Fig. 7(c) illustrates the relationship between the light-extraction efficiency (%) and the lens height h (µm) in the case with constant lens diameter d = 169.7 µm and lens surface ratio = 80.6%. The figure clearly shows that the light-extraction efficiency can be increased by increasing the lens height and the refractive index of the glass substrate. In particular, the light-extraction efficiency can be effectively increased by setting the refractive index of the glass substrate to 1.60 or more with the lens height being within a range of 5 µm to 20 µm.

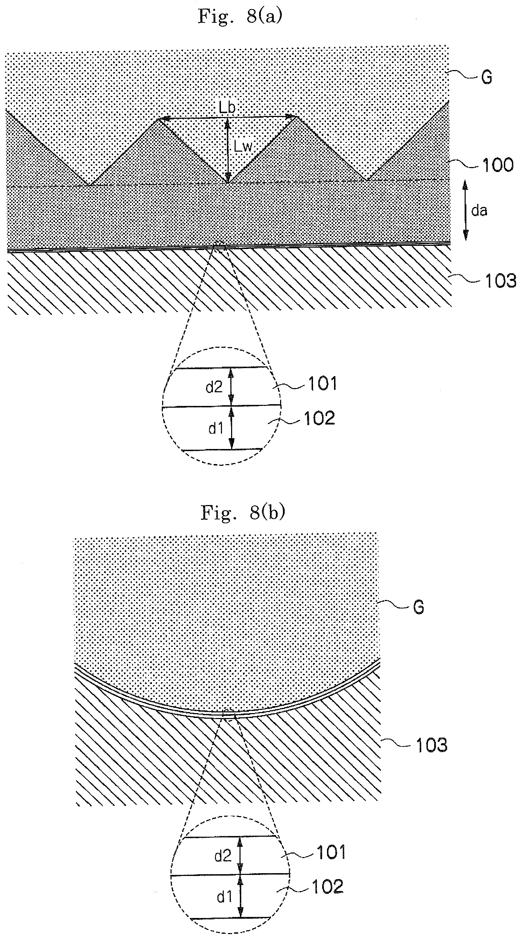

Fig. 8 depicts a model configuration of an organic EL element in the case where a relief structure is provided on the rear face side of the glass substrate G. When the relief structure is provided on the rear face side of the glass substrate G where the organic EL element is to be formed, the organic EL element can be formed by forming a high refractive layer 100 having a refractive index higher than the refractive index of the glass substrate G on the rear face of the glass substrate G to flatten the rear face side of the glass substrate G, as depicted in Fig. 8(a), and then stacking a transparent conductive layer 101, a light-emitting portion 102 composed of an organic layer, and a reflective electrode layer 103 thereupon. The organic EL element can be also formed by directly stacking the transparent conductive layer 101, the light-emitting portion 102 composed of an organic layer, and the reflective electrode layer 103 on the rear face where the relief structure has been provided, as depicted in Fig. 8(b). In either configuration, the light which returns due to complete reflection on the interface of the rear face side of the glass substrate G can be suppressed. Therefore, the light-extraction efficiency of the organic EL element can be increased. The relief structures in Figs. 8(a) and 8(b) each can be of various forms, for example, in the form of a lens array or a prism array.

The results of simulation of the light-extraction efficiency improvement effect in the model configuration of the organic EL element depicted in Fig. 8 are presented below. The results of simulation are obtained by the aforementioned light ray tracing method. In the light ray tracing method, a total of 20,000 light rays which were randomly emitted from the light-emitting face of a complete diffusion surface were traced, the light emitted to the outside from the glass substrate was detected, and the ratio of light rays that reached the sensor surface was taken as the "light-extraction efficiency".

Here, the model in which the high refractive layer 100 is provided between the glass substrate G and the transparent conductive layer 101, as depicted in Fig. 8(a), is taken as the first model, and the model in which the high-refractive layer is not provided between the glass substrate G and the transparent conductive layer 101, as depicted in Fig. 8(b), is taken as the second model. The following calculation conditions are common for the two models: the distance between the emission face of the glass substrate G and the sensor is 0.05 mm; the thickness of the glass substrate G is d3 = 0.7 mm; the refractive index of the glass substrate G is 1.65; the thickness of the transparent conductive layer 101 is d2 = 0.00015 mm; the refractive index thereof is 1.9; the thickness of the light-emitting portion 102 is d1 = 0.0002 mm; the refractive index thereof is 1.7; and the reflectance of the reflective electrode layer 103 is 85%.

### <First model>

Light emission surface area: 10 mm x 10 mm.

The thickness of the high refractive layer 100 is da = 0.02 mm, and the refractive index thereof is 1.9.

The relief structure on the light-extraction side surface of the glass substrate G is a lens array (honeycomb arrangement of convex lenses on the upper side, lens diameter d = 0.08 mm, lens height h = 0.025 mm, lens pitch p = 0.085 mm (see Fig. 6)).

The relief structure on the rear face side (transparent conductive layer side) of the glass substrate G is a prism array (prism height Lh = 0.025 mm, prism bottom side Lb = 0.05 mm (see Fig. 8(a))).

The simulation results are shown in Table 4.

**[Table 4]**

| Relief structure of glass substrate (yes/no) | | Light-extraction efficiency (%) |
|---|---|---|
| Front face side | Rear face side | |
| None (flat) | None (flat) | 26.2 |
| Lens array | None (flat) | 45.7 |
| None (flat) | Prism array | 32.0 |
| Lens array | Prism array | 51.2 |

### <Second model>

Light emission surface area: 2 mm x 2 mm.

The relief structure on the light-extraction side surface of the glass substrate G is a lens array (honeycomb arrangement of convex lenses on the upper side, lens diameter d = 0.08 mm, lens height h = 0.025 mm, lens pitch p = 0.085 mm (see Fig. 6)).

The relief structure on the rear face side (transparent conductive layer side) of the glass substrate G is a lens array (same as hereinabove).

The simulation results are shown in Table 5.

**[Table 5]**

| Relief structure of glass substrate (yes/no) | | Light-extraction efficiency (%) |
|---|---|---|
| Front face side | Rear face side | |
| None (flat) | None (flat) | 25.2 |
| Lens array | None (flat) | 38.0 |
| None (flat) | Lens array | 38.3 |
| Lens array | Lens array | 39.5 |

These simulation results clearly indicate that the light-extraction efficiency can be improved more effectively by forming a relief structure on both the light-extraction side surface and the rear face of the glass substrate G.

As mentioned hereinabove, in the organic EL element using the glass substrate according to the embodiment of the present invention as a light-extraction side transparent substrate, the light-extraction efficiency can be effectively increased. The organic EL element using the glass substrate can be used as a light-emitting element for organic EL devices for various applications, and where it is used in an organic EL illuminator in which a high brightness needs to be obtained at a low power consumption, the increase in the illuminator performance is particularly high.

### [Reference Signs List]

1: orifice, 2: first molding roller, 3: second molding roller,
10: slit orifice, 11: molding roller
Gm: melting glass, Ga: thin-plate shape glass
Gc: curtain-like glass, G (G1, G2, G3), Gb, Gd: glass substrates
M, M1, M2: curved convex part, P: conical or pyramidal convex part,
100: high refractive layer, 101: transparent conductive layer, 102:
light-emitting portion, 103: reflective electrode layer

## Claims

1. A glass substrate serving as a light-extraction side transparent substrate of an organic EL element, wherein
a refractive index λd is 1.60 or more, and Na₂O + K₂O are contained at 10 mol% to 20 mol% as glass components, and
a light-extraction side surface has a relief structure obtained by die molding.

2. The glass substrate according to claim 1, wherein the substrate contains TiO₂ at 12 mol% to 24 mol% and BaO at 5 mol% to 15 mol% as glass components.

3. The glass substrate according to claim 1 or 2, wherein a component content rate of Na₂O is larger than a component content rate of K₂O.

4. The glass substrate according to any one of claims 1 to 3, wherein K₂O is contained at 1 mol% to 10 mol% as a glass component.

5. The glass substrate according to any one of claims 1 to 4, wherein a rear face of the light-extraction side surface in said glass substrate has a relief structure obtained by die molding.

6. The glass substrate according to claim 5, wherein the relief structure of the light-extraction side surface and the relief structure of said rear face in said glass substrate are formed to be reversely symmetrical.

7. The glass substrate according to claim 5, wherein the relief structure of the light-extraction side surface and the relief structure of said rear face in said glass substrate are formed to be reversely asymmetrical.

8. The glass substrate according to any one of claims 5 to 7, wherein said relief structure is a lens array.

9. The glass substrate according to claim 7, wherein one of said relief structures on the front face and the rear face is a lens array and the other relief structure is a prism array.

10. An organic EL illuminator comprising the glass substrate according to any one of claims 1 to 9.

11. An organic EL illuminator comprising the glass substrate according to any one of claims 5 to 9, wherein
a high refractive layer having a refractive index higher than the refractive index of the glass substrate is formed on said rear face, and a transparent conductive layer of an organic EL element is formed on an upper side of the high refractive layer.

12. A method for producing a glass substrate serving as a light-extraction side transparent substrate of an organic EL element, the method comprising:
a step of molding melting glass containing TiO₂ at 10 mol% to 24 mol%, BaO at 5 mol% to 15 mol%, and Na₂O + K₂O at 10 mol% to 20 mol% as glass components into a thin-plate shape by rolling or extending; and
a step of performing die pressing for forming a relief structure on a surface of a glass substrate simultaneously with said molding step or thereafter.

13. The method for producing a glass substrate according to claim 12, wherein a die which is used in said step of performing die pressing has a die inner surface which is not in contact with a surface of a curved convex part formed on the glass substrate.

14. The method for producing a glass substrate according to claim 12 or 13, wherein said step of performing die pressing is performed simultaneously on a front face and a rear face of said glass substrate.
